## Europäisches Patentamt

## European Patent Office

## Office européen des brevets

(11) Publication number: **0 180 322**
**B1**

# EUROPEAN PATENT SPECIFICATION

(45) Date of publication of patent specification: **03.05.89**

(51) Int. Cl.⁴: **G 01 R 31/12**

(21) Application number: **85306863.3**

(22) Date of filing: **26.09.85**

(54) Partial discharge measuring device.

(30) Priority: **28.09.84 JP 203686/84**
**20.12.84 JP 268979/84**
**28.01.85 JP 14102/85**
**19.09.85 JP 207590/85**

(43) Date of publication of application:
**07.05.86 Bulletin 86/19**

(45) Publication of the grant of the patent:
**03.05.89 Bulletin 89/18**

(84) Designated Contracting States:
**CH DE GB LI SE**

(56) References cited:
**US-A-3 707 673**

**PATENT ABSTRACTS OF JAPAN, vol. 2, no. 45
(E-78), 27th March 1978, page 589 E 78; &
JP-A-53-9583**

**PATENT ABSTRACTS OF JAPAN, vol. 2, no. 104
(E-78), 26th August 1978, page 5489 E 78; &
JP-A-53-70473**

(73) Proprietor: **FUJI ELECTRIC CO., LTD.**
**1-1, Tanabeshinden, Kawasaki-ku
Kawasaki-shi Kanagawa 210 (JP)**

(72) Inventor: **Kawabata, Osamu c/o Fuji Electric
Company Ltd
No. 1-1, Tanabeshinden Kawasaki-ku
Kawasaki-shi Kanagawa (JP)**

(74) Representative: **Skone James, Robert Edmund
et al
GILL JENNINGS & EVERY 53-64 Chancery Lane
London WC2A 1HN (GB)**

Courier Press, Leamington Spa, England.

## Description

This invention relates to a partial discharge measuring device for measuring partial discharge pulses produced in a gas-insulated electric apparatus, such as a gas-insulated sealed circuit breaker, a gas-insulated cable or a gas-insulated transformer, or a high voltage apparatus such as a high-voltage rotary electric machine or a device with solid insulation, such as resin moulded transformer, separately from electric noise. It relates, particularly, to such measuring device having a noise reduction circuit for reducing or removing single shot noise or periodic noise overlapping the partial discharge pulse and having a rise and/or fall time which is longer than the duration of the pulse.

When a characteristic of a sample apparatus is to be evaluated by measuring or observing the waveform, the amplitude, and/or the frequency of occurrence of the partial discharge pulse signal, and the level of noise, such as periodic noise due to a broadcast wave being introduced into the measuring circuit due to the apparatus acting as an antenna, on-off noise introduced via a power transmission system into the measuring circuit, or single shot noise such as electric discharge noise, is high, the signal/noise (S/N) ratio of the measuring circuit, etc., is lowered, and hence the accuracy of evaluation is degraded.

In order to reduce noise, it has been usual to use a filter having a passband within which the main frequency components of the pulse signal are included. If the passband is made narrower to improve the S/N ratio, the pulse signal waveform may be distorted or oscillate, and if the passband is made wider, the S/N ratio for noise having a waveform which is closer to that of the main frequency component of the pulse signal is reduced. That is, it is practically impossible to obtain a noise reduction circuit having a characteristic which satisfies both the noise reduction requirement and the original waveform maintaining requirement (see also US-A- 3707673).

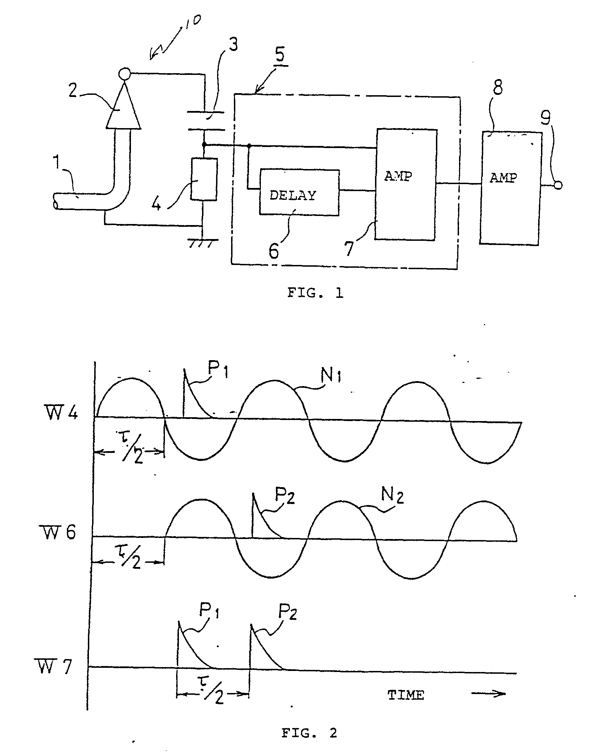

Figure 1 of the accompanying drawings is a block schematic diagram of a conventional noise reduction circuit which is applied to a partial discharge testing circuit for a high-voltage electric device, such as a power cable 1, which is to be tested. The circuit comprises a terminal bushing 2 for applying a test voltage to the power cable 1, an input circuit 10 comprising a coupling capacitor 3 for partial discharge pulse detection and a detection impedance 4, a noise removing circuit 5 comprising a delay line 6 and an adder circuit 7, and an amplifier 8 for amplifying the partial discharge pulse.

Figure 2 shows signal waveforms W4, W6 and W7 for explaining the operation of the noise reduction circuit. The waveform W4 is the output signal waveform of the input circuit 10, i.e. the terminal voltage at the detection impedance 4. The waveform W6 is the output signal waveform of the delay line 6 and the waveform W6 is the output signal waveform of the adder 7. The signal W4 includes a partial discharge pulse P1 which is to be detected and a periodic noise signal N1 having a period T. The delay line 6 is designed to have a delay time (t/2) corresponding to half of the period of the periodic noise N1, so that the output waveform W6 includes a noise signal N2 and a discharge pulse P2 which are delayed relative to the input signals N1 and P1, respectively, by T/2. As a result, the phases of the noise components NI and N2 of the input signals W4 and W6 to the adder 7 are opposite to each other and are cancelled out in the adder 7. Only the discharge pulses P1 and P2 are supplied to the amplifier 8 and are fed out from its output terminal 9 after amplification, as shown by the waveform W7.

In this circuit construction, since the periodic noise in the waveform W6 is delayed by a half period, it is necessary to regulate the delay time of the delay line 6 such that it coincides with the period of the periodic noise. In addition, if a plurality of periodic noise signals are present, a corresponding number of noise removing circuits are required.

An object of the present invention is to provide a partial discharge measuring device equipped with a noise reduction circuit which is capable of attenuating or removing single shot noise having rise and fall times which are long compared with the duration of a partial discharge pulse and/or periodic noise, without deformation of the partial discharge pulse waveform.

According to the invention, there is provided a partial discharge measuring device for use with high voltage apparatus, the device being responsive to an input first signal composed of a partial discharge pulse signal having a pulse width in a predetermined time range and overlapped therewith a single shot or periodic noise signal having a rise or fall time longer than said predetermined time range; characterised by a first phase shift/reduction circuit for producing a second signal delayed relative to said first signal by a predetermined time and for producing a third signal as the difference between said second signal and said first signal; a second phase shift/reduction circuit for producing a fourth signal by delaying said third signal by the predetermined time and for producing a fifth signal as the difference between said fourth signal and said third signal; and a phase shift/multiplying circuit for producing a sixth signal by delaying said fifth signal by a time twice the predetermined time and for multiplying said fifth and sixth signals together to provide the partial discharge pulse signal substantially without any said noise signal.

The pulse width of the partial discharge pulse depends upon the kind of defect in the high voltage device. In order to measure a partial discharge pulse occurring in a gas such as $SF_6$ gas in a gas insulated sealed circuit breaker (GIS), the delay time of the phase shift/reduction circuit may be set from 2nS to 4nS. On the other hand, when a discharge pulse produced in a small void in a solid insulator, such as an insulating spacer, isto be measured, the delay time may be set from 10nS to 30nS.

The reducing circuit portion of the phase shift/reduction circuit and the multiplying circuit portion of the phase shift/multiplying circuit may be constituted, respectively, by operational amplifiers. However, when there is a probability of a high surge voltage entering the measuring system during the measurement, it is advisable to constitute the phase shift/reduction circuit with a 180° distributor composed of a high frequency transformer and a mixer comprising a high frequency transformer or resistance means and to connect it through the delay circuit to the input circuit.

By use of the present invention, other partial discharge pulses having rise and fall times each longer than the delay time provided by the phase shift/reduction circuit can also be removed as noise. By making the delay time variable, according to the kinds of partial discharge and measuring discharges, the kind of discharge produced in the device to be tested can be identified.

When the device to be tested is an $SF_6$ gas insulated device such as a GIS device, the input to the first phase shift/reduction circuit is supplied through a bandpass amplifier the passband of which may be from 50 MHz to 1000MHz.

The upper limits of frequency components of the partial discharge pulse in $SF_6$ gas and the void discharge pulse are distributed in a range from 50MHz to 2000MHz, while the upper frequency limit of thyristor noise, that of a partial discharge pulse in oil in an oil-filled device, and that of a corona pulse in a power transmission line are substantially 10MHz or lower, several MHz or lower and 10MHz or lower, respectively. Therefore, the S/N ratio of the measuring device can be improved by blocking these lower frequency regions.

Embodiments of the invention will now be described, by way of example, with reference to the accompanying drawings, in which

Figure 1 shows the construction of a conventional noise removing circuit for a partial discharge test circuit for a power cable, as described above.

Figure 2 shows waveforms for explaining the operation of the circuit of Figure 1;

Figure 3 is a block schematic diagram showing a main portion of an embodiment of the present invention;

Figure 4 shows signal waveforms for explaining the operation of the circuit of Figure 3 when the input signal contains shot noise;

Figure 5 shows signal waveforms for explaining the operation of the circuit of Figure 3 when the input signal contains periodic noise;

Figure 6 shows characteristic curves relating to signal/noise (S/N) ratio of the circuit of Figure 3;

Figure 7 shows signal waveforms when the delay time is different from that by which the signal waveforms in Figure 4 are obtained;

Figure 8 depicts waveforms showing the directions of the partial discharge pulse signal and the external noise;

Figure 9 is a circuit diagram of a phase shift/reduction means used in another embodiment of the present invention;

Figure 10 shows signal waveforms for explaining the operation of the circuit in Figure 9;

Figure 11 is a block schematic diagram of another embodiment of the present invention;

Figure 12 shows waveforms for explaining the operation of the circuit of Figure 11;

Figure 13 shows waveforms similar to those in Figure 12 when the delay time of the circuit is different;

Figure 14 is a graph showing the relative magnitude ratio of frequency components of the partial discharge pulse signal and the external noise;

Figure 15 is a schematic circuit diagram showing another embodiment of the present invention, which has a band amplifier connected to the input side thereof;

Figure 16 shows the waveform of the output signal of the band amplifier in Figure 15; and

Figure 17 shows the waveform of the output signal of the partial discharge measuring device of Figure 15.

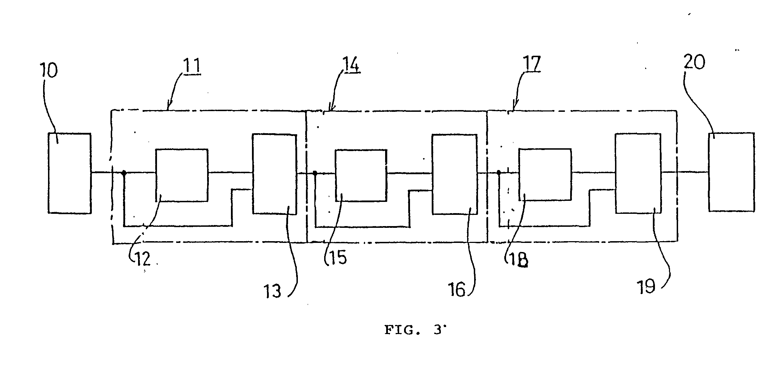

Figure 3 is a schematic block diagram of an embodiment of the present invention. The apparatus comprises an input circuit 10, which may be an impedance matching circuit, from which a pulse signal which contains noise and which is to be measured is fed out as an analog signal having a waveform corresponding to the original waveform thereof. A first phase shift/reduction circuit 11 and a second phase shift/reduction circuit 14 are connected in series to the first circuit 11. Each of the phase shift/reduction circuits 11 and 14 comprises a delay circuit 12 (or 15) such as a delay line or a coaxial cable having a delay time Td equal to the duration Wp of the partial discharge pulse signal, and a reduction circuit 13 (or 16) having inputs supplied with input and output signals of the delay circuit 12 (or 15).

A phase shift/multiplying circuit 17 has an input supplied with the output signal from the second phase shift/reduction circuit 14. The phase shift/multiplying circuit 17 comprises a delay circuit 18 having a delay time (2Td) twice the delay time Td of the first (or second) phase shift/reduction circuit and a multiplying circuit 19 having inputs supplied with input and output signals of the delay circuit 18. An output circuit 20 is connected to the output of the multiplying circuit 19. The circuit 20 may comprise any, or a combination of any, of a square-root circuit, an amplifier circuit, an alternating circuit and an impedance-matching circuit etc., according to requirements.

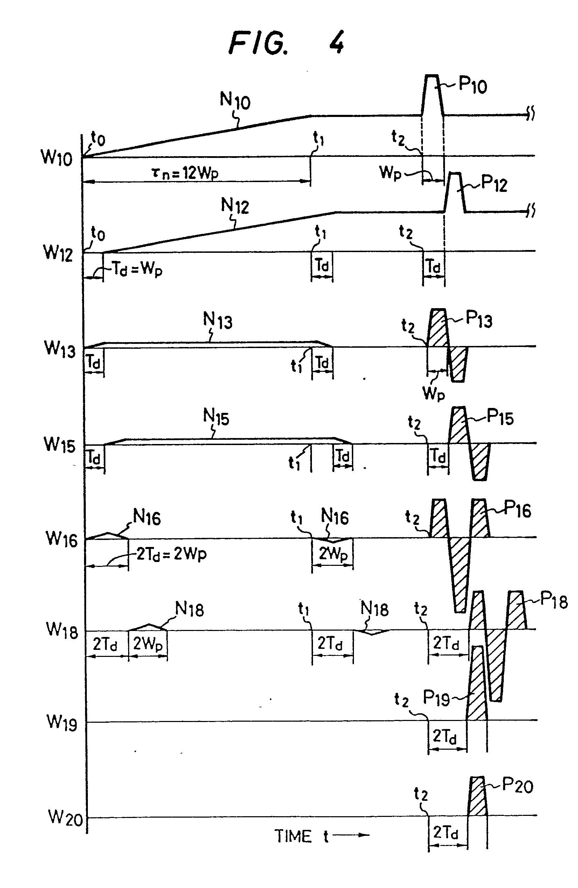

Figure 4 shows signal waveforms for explaining the operation of the partial discharge measuring device shown in Figure 3. In Figure 4, it is assumed that an input signal contains a pulse signal P10 to be measured, which has a trapezoidal waveform the duration or pulse width Wp of which is 50nS, and single shot noise N10 which has a trapezoidal waveform having a rise (or fall) time Tn of 600nS, which is 12 times the pulse width Wp. As the delay circuit of the phase shift/reduction circuit, a delay line available from Showa Densen Co. under the trade name of Single-In-Line type AT is used, which provides a delay time Td equal to the pulse width of the pulse P10. As the reduction circuit and the multiplying circuit a wide-range operational amplifier available from OEI as model No. 9826 and a wide range linear multiplier available from Analog Devices as model No. AD539 are used, respectively. The circuit constructed with these components may be suitable to maintain the original waveform of the pulse signal the pulse width Wp of which is as short as 50nS. For a substantially different pulse width Wp and delay time Td, the circuit components should be changed accordingly.

In Figure 4, the output signal waveform of the input circuit is shown as waveform W10, which contains the trapezoidal noise N10 and the trapezoidal pulse signal P10 which is to be measured and which starts at a time instant t2. The noise N10 starts at a time instant t0 has a rise time Tn which is 12 times the pulse width Wp of the pulse signal P10 and a fall time Tn which, for the sake of simplicity, is not shown.

The signal W10 passes through the delay circuit 12 of the first phase shift/reduction circuit 11 and is delayed by Td, as shown by a waveform W12. The waveform W12 contains a noise signal N12 which is delayed from t0 by Td(=Wp) and a pulse signal P12 which is delayed from t2 by Td. The waveforms of the noise signal N12 and the pulse signal p12 are substantially the same as those of the noise signal N10 and the pulse signal p10, respectively.

The output of the reduction circuit 13 has a waveform W13 which is the wave form W10 minus the waveform W12. That is, the waveform W13 contains a trapezoidal noise signal N13 which rises at the time instant t0 with a rise time Td and falls at a time instant t1, corresponding to the end of the period Tn, with a fall time Td and a pulse series P13 composed of a trapezoidal pulse which is the same in shape and timing as the pulse P10 and a trapezoidal pulse which is the same in shape and timing as, but opposite in polarity to, the pulse P12. The amplitude of the noise signal N13 is reduced to about one twelfth the amplitude of the input noise pulse N10 and the width thereof is shortened to (Tn + Td).

Waveforms W15 and W16 are waveforms of output signals of the delay circuit 15 and the reduction circuit 16 of the second phase shift/reduction circuit 14, respectively. That is, the waveform W15 is composed of a pulse signal P15 and a noise signal N15 and comprises the waveform W13 delayed by Td. The waveform W16 is obtained by subtracting the waveform W15 from the waveform W13. The waveform W16 contains a pair of triangular positive and negative noise signals N16 having a width of 2Td=2Wp and starting at the time instant t0 and tl, respectively, together with a pulse signal P16 composed of three pulses starting at the time instant t2.

Waveforms W18 and W19 are waveforms of output signals of the delay circuit 18 and the multiplying circuit 19 of the phase shift/multiplying circuit 17, respectively. The waveform W18 contains two noise signals N18 and a pulse series P18 composed of three pulses. This comprises the waveform W16 delayed by the delay circuit 18 by 2Td. The waveform W19 is obtained by multiplying the waveform W16 by the waveform W18 in the multiplying circuit 19. The waveform W19 contains only one pulse P19 which is the product of simultaneously occurring ones of the pulses in the pulse trains P16 and P18 and starts at a time instant delayed from the time instant t2 by 2Td.

If the output circuit 20 comprises a square-root circuit, the waveform W19 is square-rooted thereby, resulting in a waveform W20 which is a final output signal of the partial discharge measuring device and which has an amplitude and pulse shape similar to those of the original waveform.

Since there is some attenuation of the signal during the transmission, even though the delay circuit comprises components having good high frequency response and the components constituting the reduction circuit provide some amplification, the output circuit 20 may be constituted by any of, or any combination of, the square root circuit, an amplifier and an attenuation circuit, according to the requirements for compensation for different signals transmitted through the whole measuring device.

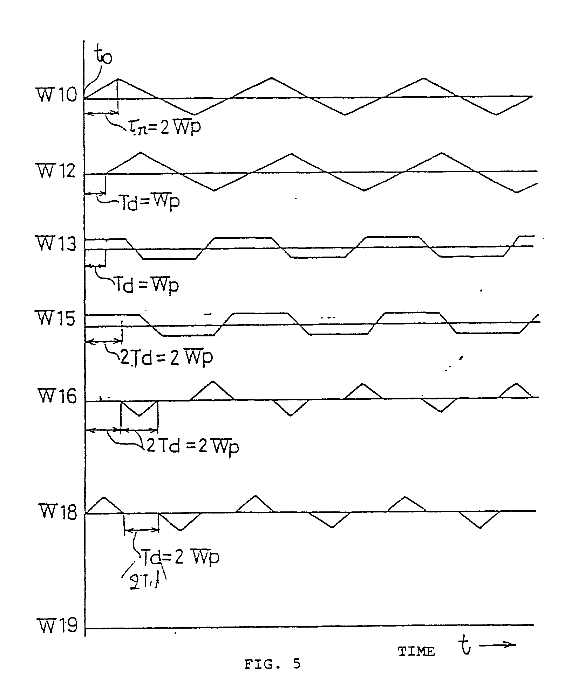

Figure 5 shows signal waveforms for explaining the operation of the partial discharge measuring device in Figure 3 with respect to a periodic noise signal which, in this case, is an alternating triangular wave having a rise time (and fall time) Tn which is twice the pulse width Wp of the pulse signal to be measured. In Figure 5, the output signal W10 of the input circuit 10 is the alternating triangular noise signal. The noise signal W10 is delayed by the delay circuit 12 of the first phase shift/reduction circuit 11 by Td=Wp, resulting in a waveform W12. The waveform 10 is reduced by subtracting the waveform W12 in the reduction circuit 13, resulting in a trapezoidal waveform W13 the magnitude of which is a half the amplitude of the noise signal W10 or W12.

The noise signal having the waveform W13 is delayed by the delay circuit 15 of the second phase shift/reduction circuit 14 by Td=Wp, resulting in a waveform W15. The waveform W13 is reduced by subtracting the waveform W15 in the reduction circuit 16 of the second phase shift/reduction circuit 14, resulting in a waveform W16 which is a series of alternating triangular pulses occurring at the same timing as that of the waveform W10 with a delay of 2Td and each having a pulse width and magnitude which are substantially equal to those of the original noise waveform having a rise time Tn=2Wp.

The waveform W16 is delayed by 2Td by the delay circuit 18 of the phase shift/multiplying circuit 17, resulting in a waveform W18. The waveforms W16 and W18 are multiplied together by the multiplier 19, resulting in a waveform W19. Therefore, the periodic noise can be completely removed.

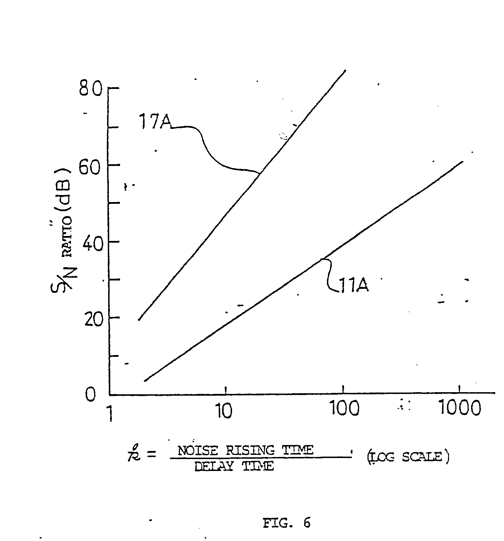

Figure 6 is a graph showing a plot of signal/noise (S/N) ratio of the partial discharge measuring device shown in Figure 3, obtained by using the rise time (fall time) of the noise as a variable. In Figure 6, the coordinate shows the S/N ratio and the abscissa shows the ratio k= (noise rise time (Tn))/delay time (Td)). A curve 11A shows the S/N ratio of the output signal of the first phase shift/reduction circuit 11 and a curve 17A the S/N ratio of the output signal of the phase shift/multiplying circuit 17.

The curve IIA is a straight line approximated by S/N ratio ≒ 20 log k (dB) since the noise is trapezoidal having a linear rise portion. Furthermore, although the S/N ratio of the output signal of the phase shift/multiplying circuit theoretically becomes infinite, it becomes, in practice, as shown, due to influences such as feed-through noise of the multiplying circuit.

In general, the longer the rise or fall time Tn compared with the delay time Td of the delay circuit, i.e. the pulse width of the partial discharge pulse signal, the better the S/N ratio. In the partial discharge measuring device shown in Figure 3, it is possible to reduce the noise level to about one tenth, even in a condition where Tn/Td=2 and the noise level can be reduced to one hundredth or lower in a condition where Tn/Td=10.

As mentioned, in handling a noise signal which has a rise time Tn longer than the delay time Td of the delay circuit, the first phase shift/reduction circuit 11 functions to reduce the noise level by delaying by Td the input signal to be supplied to one of the inputs of the reduction circuit 13, the second phase shift/reduction circuit 14 functions to divide the noise into a plurality of discrete noise pulses by delaying the input signal to be supplied to one of the inputs of the reduction circuit 16, and the phase shift/multiplying circuit 17 functions to make the result of multiplication zero by preventing overlapping of the discrete noise pulses, so that the noise is substantially eliminated. On the other hand, in handling the partial discharge pulse signal, it is important to maintain the original waveform of the pulse signal. It means that, in choosing the circuit components, the high frequency response thereof is important and these components should be combined so that three pulses produced by passing the pulse signal through the phase shift/reduction circuits are, on the one hand, supplied to the multiplying circuit directly and, on the other hand, delayed and supplied to the multiplying circuit such that only one of the three pulses which are not delayed and only one of the three delayed pulses are overlapped in time, the remaining pulses being cancelled out by the multiplication. Thus, the three circuits 11, 14 and 17 function independently of each other and, therefore, if the ratio Td/Wp is very large, a sufficient noise reduction can be provided using only the first phase shift/reduction circuit. Thus, it may be possible to constitute a noise removing circuit by using the first phase shift/reduction circuit independently.

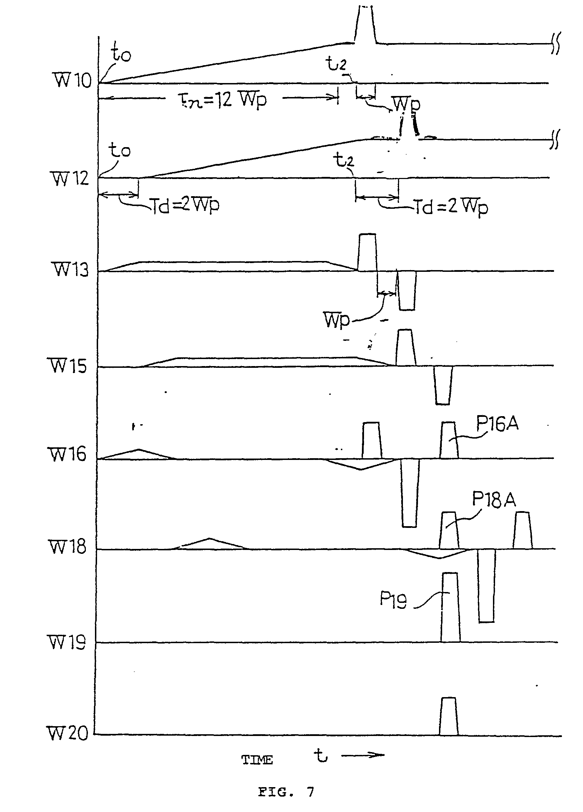

Figure 7 shows another example of noise removal by using the circuit construction shown in Figure 3, in which the delay time Td is set as being twice the pulse width Wp of the partial discharge pulse.

In this example, the delay times of the delay circuits 12 and 15 are each selected as being 2Wp, and that of the delay circuit 18 is set as 4Wp. As a result, waveforms W13, W15, W16 and W18 in Figure 7 include space times Wp between the pulse signals. However, in the phase shift/multiplying circuit, a pulse P16A of the waveform W16 coincides in time with a pulse P18A of the waveform W18, resulting in a signal pulse signal P19 at the output of the multiplying circuit 19, as in the case of Figure 4. Furthermore, since Td=2Wp, the ratio Tn/Td=k is smaller, and hence the S/N ratios of the output signals of the circuits 11, 14 and 17 become about a half (6dB) of those obtained in the Figure 4 embodiment, as shown in Figure 6. That is, the delay time Td of the delay circuits 12 and 15 is not always equal to the width Wp of the pulse signal to be measured and thus it may be possible to set the delay times relatively long, taking into consideration variations in the width of the pulse signal to be measured.

In Figures 4 and 7, the partial discharge pulse signal is trapezoidal and has a width Wp=50nS. It should be noted, however, that the present device is also effective to provide an output having a waveform very close to the original signal waveform, even when it is an alternating waveform as shown in Figure 2, or other waveforms including oscillating components, provided that the circuit components have a good high frequency response.

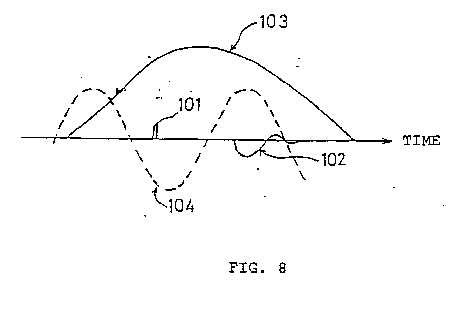

Figure 8 illustrates a partial discharge pulse and external noise contained in a detection signal from a GIS device, in which pulses 101 and 102 show internal coronas, each having a width of several nS, produced in SF$_6$ gas and internal void coronas each having a width of several tens of nS which are produced in small voids in solid insulators such as spacers etc, respectively. An external noise pulse 103 and continuous external noise 104 are superimposed on these internal coronas. The external noise 103 includes a transmission cable corona having a width of several hundreds of nS produced in an overhead power transmission line and a thyristor pulse having a width of several μs produced by a thyristor such as an inverter, as well as corona having a rise time of lμS and a width of several μs produced in the oil in an oil-filled cable or an oil-filled transformer, when the device to be tested is a gas-insulated device or a solid insulator device. These external noise signals disturb the monitoring of the internal coronas. The continuous external noise 104 includes a broadcast wave and a carrier wave (several tens to several hundreds of KHz) for inter-power-plant communication.

By use of the present invention, it is possible to measure a partial discharge pulse in SF$_6$ gas of a GIS device etc., by setting the delay time of the phase shift/reduction circuit at 2nS to 4nS, and to measure a discharge pulse produced in a small void in a solid insulator, such as an insulating spacer, by setting the delay time at 10nS to 30nS.

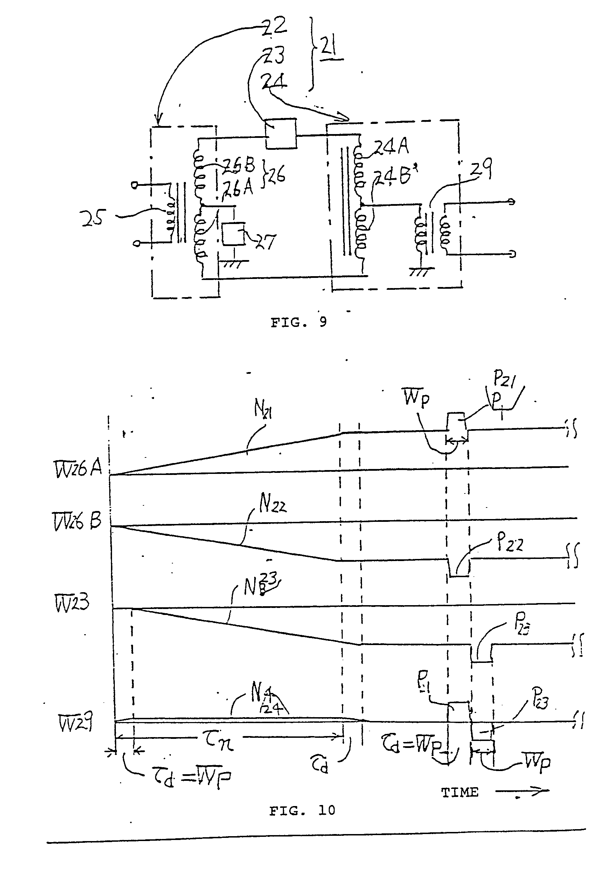

Figure 9 shows another embodiment of a phase shift/reduction circuit used in the present invention. In Figure 9, the phase shift/reduction circuit 21 comprises a 180° distributor 22 comprising a high frequency transformer, a delay circuit 23 connected to one side or the other of a secondary winding 26 of the transformer, and a mixer 24 connected through the delay circuit 23 to the secondary winding 26 of the 180° distributor 22.

A partial discharge signal containing noise is divided into a non-inverted signal and an inverted signal by the 180° distributor 22 between which a time difference corresponding to a pulse width of the input pulse signal is given by the delay circuit 23. The mixer 24 adds the inverted and non-inverted signals, separated in time as above, to obtain a signal representing the difference therebetween. The 180° distributor 22 preferably comprises a high frequency transformer having a ferrite core (e.g. Ferrite Transformer (trade name) type HYB-1 available from R & K Co.). The secondary winding 26 is grounded at a centre point thereof through a matching resistor 27 to provide a pair of coil portions 26A and 26B which are symmetrical with respect to the centre point, to provide a 180° distributor which is of low loss over a frequency range up to several hundred MHz, according to the principle of distributed constant circuits. By suitably providing an insulating coating on the coils, or by immersing the coils in a resin, it is possible to produce economically a 180° distributor which has a breakdown voltage of several thousand volts and which is compact in size. The delay circuit 23 may be fabricated by using a delay cable, an LC delay line or a coaxial cable of a desired length, with a high breakdown voltage characteristic. The mixer 24 may comprise a ferrite core mixer having parallel coils 24A and 24B, such as the Power Combiner (trade name) device of the P & K Co., and a high frequency output transformer 29, connected between a junction of the coils 24A and 24B and a ground point, and acting as an impedance matching circuit.

Figure 10 explains the operation of the phase shift/reduction circuit shown in Figure 9, when an input pulse to be supplied to the primary winding 25 of the 180° distributor 22 is composed of a pulse signal P21 to be measured, having a trapezoidal waveform with a pulse width Wp of 50nS and a single shot noise signal N21 of trapezoidal shape having a rise or fall time T n which is 12 times the pulse width Wp, i.e. 600 nS, overlapped therewith, the falling portion of the noise signal N21 being omitted. In Figure 10, waveforms W26A and W26B are voltage waveforms of the coil 26A (non-inverted side) and 26B (inverted side) of the secondary winding 26 of the 180° distributor 22 with respect to ground potential, respectively. That is, a non-inverted signal P21 and noise N21, and an inverted signal P22 and noise N22 are provided by the distributor.

The inverted signal P22 and the noise signal N22 are passed through the delay circuit 23 having a delay Td=Wp, resulting in a waveform W23 which is composed of a noise signal N23 delayed by Td=Wp with respect to the signal N22 and a pulse P23 delayed by Wp. The non-inverted signals N21 and P21 and the delayed signals N23 and P23 are supplied to the mixer 24 and are added to each other therein, resulting in a difference signal at the output of the power transformer 29, which has a waveform W29 composed of a trapezoidal noise signal N24 of reduced level, a pulse substantially the same as the pulse P21 and a pulse P23 which is substantially the same as the pulse P21 but inverted. The noise reduction ratio with respect to the original noise N21 is proportional to the ratio Tn/Td and is, therefore, about 1/12 in the embodiment shown.

Using the phase shift/reduction circuit constituted by the 180° distributor comprising a ferrite core high-frequency transformer, the mixer 24 having a similar structure to the transformer, the output transformer 29 and the delay circuit 23, a noise removing effect similar to that obtainable in the preceding embodiment is obtained. Furthermore, the high frequency transformer and the mixer may have a higher breakdown voltage against surge voltage than the high speed operational amplifier used for the reduction circuit in the preceding embodiment by about two digits, and may be lower in cost than the operational amplifier by about one digit. Therefore, when the noise removing circuit of the partial discharge measuring device for high voltage apparatus is constituted by the above mentioned phase shift/reduction circuit, which is durable against switching surges or lightening surges which may be several thousand volts, and which may be introduced through the high voltage apparatus into the measuring device, the noise removing device can also serve as a protection circuit for the measuring device including electronic circuits arranged in the output side of the phase shift/reduction circuit, because a surge voltage having a duration of the order of microseconds can be reduced in amplitude by a factor of several hundreds in the phase shift/reduction circuit.

Although, in Figure 9, the mixer 24 comprises the coils 24A and 24B and the high frequency output transformer 29, these elements may be replaced by resistors if some increase in loss in the mixer is allowable. If the output transformer 29 is connected as the input side of the mixer 24, the latter can be used as the 180° distributor. In that case the 180° distributor 22 can be used as the mixer.

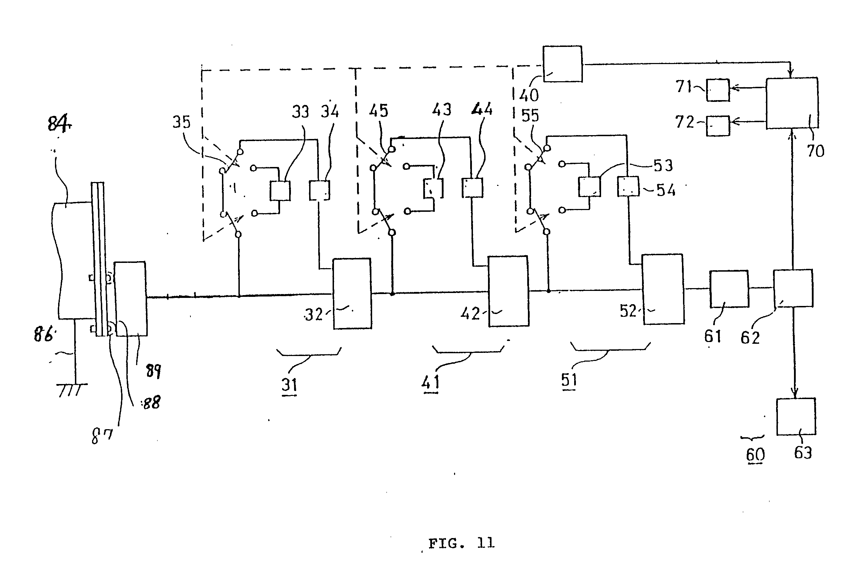

Figure 11 is a block circuit diagram of a partial discharge monitoring device according to another embodiment of the present invention. In Figure 11, the device comprises an input circuit 89 directly connected by detection terminals 88 of, for example, a resilient contactor, to a pair of bolts 87 of a grounded metal portion of a high voltage apparatus, for example a metal container 84 of a GIS device. The device also comprises series- connected phase shift/reduction circuits 31 and 41, a phase shift/multiplying circuit 51, an output circuit 60 comprising an amplifier 61 and a peak hold circuit 62, a measuring device 63 such as a waveform monitor or counter, a discriminator 70 and display devices 71 and 72 for displaying, respectively, void corona and corona in $SF_6$ gas. The phase shift/reduction circuit 31 includes two delay circuits 33 and 34 having delay times of 8nS and 2nS, respectively, and a reduction circuit 32. The phase shift/reduction circuit 41 includes a pair of delay circuits 43 and 44 having delay times of 8nS and 2nS, respectively, and a reduction circuit 42. The delay circuits of the phase shift/reduction circuits 31 and 41 can be selectively connected in circuit by changeover switches 35 and 45, under the control of a changeover control circuit 40, so that each of these delay circuits can provide delay times of 2nS or 10nS.

The phase shift/multiplying circuit 51 includes delay circuits 53 and 54 having delay times of 16nS and 4nS, respectively, and a multiplier circuit 52. The delay circuits 53 and 54 are controlled by a changeover switch 55 so that they can provide a delay of 4nS or 20nS.

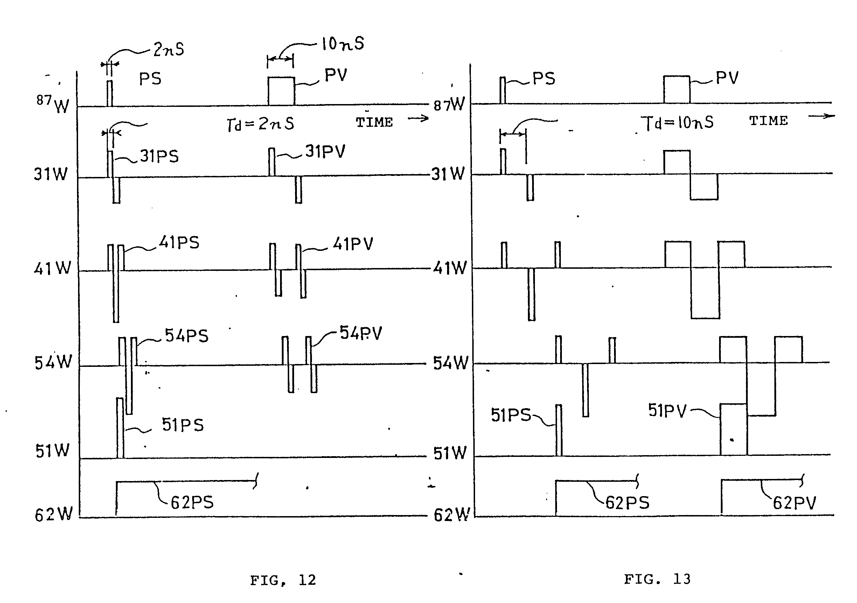

Figures 12 and 13 show partial discharge pulses in the embodiment in Figure 11, with the noise waveform being omitted. In Figure 12, the delay time of each of the phase shift/reduction circuits 31 and 41 is made equal to 2nS which is substantially equal to the pulse width of a corona pulse PS in $SF_6$ gas and, in Figure 13, it is made equal to 10nS which is substantially equal to the pulse width of a void corona pulse PV. In these Figures, the waveform of each pulse is assumed to be rectangular, for simplicity of explanation. These Figures show the input waveform 89W of the phase shift/reduction circuit 31, the output waveform 31W of the circuit 31, the output waveform 41W of the circuit 41, the output waveform 54W of the delay circuit 54 of the phase shift/reduction circuit 51, and the output waveform 62W of the peak hold circuit 62.

In Figure 12, the corona pulse PS produced in $SF_6$ gas is delayed by 2nS and is reduced, in the same way as mentioned previously, in the phase shift/reduction circuit 31, resulting in a pulse series 31PS composed of 2 pulses. The latter pulse series is delayed by 2nS and is reduced similarly in the phase shift/reduction circuit 41, resulting in a pulse series 41PS composed of three pulses. The pulse series 41PS is delayed by 4nS by the delay circuit 54 and a resultant pulse series 54PS is multiplied by the pulse series 41PS in the phase shift/multiplying circuit 51, resulting in a single corona pulse 51PS having increased magnitude. The pulse 51PS is further amplified by the amplifier 61 and is processed by the peak hold circuit 62, which may comprise an integration circuit, etc., to convert it into a rectangular pulse 62PS suitable for monitoring. The rectangular pulse 62PS is supplied to the measuring device 63 and the discrimination circuit 70.

On the other hand, the void corona pulse PV is converted by the phase shift/reduction circuit 31 into a pulse series 31PV comprising two pulses each having a width of 2nS, and through a pulse series 41PV to a pulse series 54PV similarly. Since there are no pulses in the series 41PV and 54PV which occur simultaneously, the noise signals are removed by the multiplier circuit 51.

If the delay time is changed to 10nS, the pulses PS and PV appear at the outputs of the phase shift/multiplier circuit 51 as pulses 51PS and 51PV, respectively, as shown in Figure 13, and the peak hold circuit 62 provides pulses 62PS and 62PV. The discriminator circuit 70 operates to compare an input pulse before a changeover of the delay circuit with an input pulse after the changeover, at a time point in the changeover to judge a detection pulse as a void corona if it is detected only when Td=10nS and to send the detection pulse to the display device 71 for display. If it detects any pulse when Td=2nS as well as 10nS, it judges the pulse as a corona in $SF_6$ gas and sends it to the display device 72. Thus, it is possible to judge whether the detected pulse is due to a void corona or a corona in gas.

When the apparatus to be tested is an $SF_6$ gas insulated apparatus, both a void corona and a corona in the gas are due to the internal partial discharges, and when the apparatus is a solid material insulated apparatus, a void corona is due to an internal partial discharge and a corona in gas is due to external noise.

In order to discriminate a corona in oil from a void corona and a corona in gas, it may be enough to add a further selection of the delay of 500-1000nS.

When the apparatus to be tested is an $SF_6$ gas insulated or a solid material insulated apparatus, a bandpass amplifier having a passband Wb of 50MHz to 1000MHz and a noise blocking range below the passband is added to the input side of the measuring device. With this construction, external pulsating noise, such as thyristor noise, power cable corona pulses, discharge pulses in oil, and external continuous noise such as a broadcasting wave, are effectively reduced.

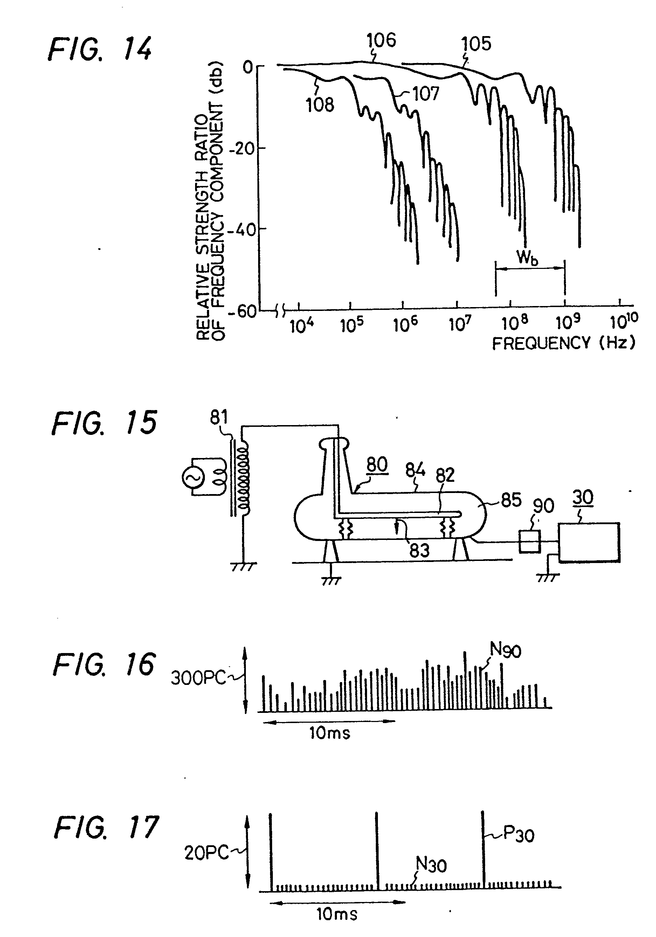

Figure 14 is a graph showing the relative strengths of frequency components of partial discharge pulses and noise pulses. In Figure 14, a curve 105 depicts the relative strength of frequency components of a partial discharge pulse in $SF_6$ gas, a curve 106 depicts that for a void discharge pulse, a curve 107 depicts that for commutation noise of a thyristor and a curve 108 depicts that for a partial discharge pulse in oil. As is clear from Figure 14, upper frequency limits of the partial discharge in SF6 gas and the void discharge are distributed over a frequency range from 50MHz to 2000MHz, while upper limits for the commutation noise, the discharge pulse in oil produced in an oil-filled device and for power cable corona are distributed in ranges below about 10 MHz, below several MHz and below about 10MHz, respectively.

Figure 15 shows an embodiment of the present invention in which a bandpass amplifier 90 is added to the embodiment shown in Figure 11. In Figure 15, an apparatus 80 comprising a sealed container 84 which contains a high voltage bus 82 and is filled with $SF_6$ gas 85 at about $3Kg.f/cm^2$ is used as a sample to be tested. A partial discharge measuring device 30, constructed as shown in Figure 11, is connected through the bandpass amplifier 90 to the sealed container 84. An A.C. voltage of 12 KV is applied from a high-voltage source 81 to the bus 82 to produce a partial discharge in the gas at a protrusion 83 on the bus 82. The partial discharge signal is supplied, together with thyristor noise of about 3000PC produced by a thyristor inverter (not shown) connected in parallel to the power source 81, through the amplifier 90 to the test circuit 30.

The delay time Td of each of the phase shift/reduction circuits is set at 10nS and the passband of the amplifier is 50MHz to 1000 MHz. The output signal of the bandpass amplifier 90 is shown in Figure 16. In Figure 16, although the high-frequency thyristor noise N90 is reduced to about 300 PC by the amplifier 90, it is impossible to detect the partial discharge in $SF_6$ gas produced at the protrusion 83. On the other hand, as shown in Figure 17, the thyristor noise N30 is reduced to one tenth according to the S/N ratio shown in Figure 6 and, therefore, the partial discharge pulse in $SF_6$ gas of about 20PC, which in Figure 16 is hidden in the thyristor noise N90, can be outputted as P30 which is detectable.

As described hereinbefore, the partial discharge measuring device comprises a first phase shift/reduction circuit composed of a delay circuit having a delay time corresponding to a duration of a partial discharge pulse and a reduction circuit for providing an attenuation effect to noise having rise and fall times each longer than the delay time, a second phase shift/reduction circuit having the same construction as that of the first phase shift/reduction circuit for converting an output noise pulse of the latter into a noise pulse series comprising a plurality of discrete pulses each having reduced pulse width, and a phase shift/multiplying circuit composed of a delay circuit having a delay time twice the delay time of the first or second phase shift/reduction circuit and a multiplying circuit for removing the noise pulse series. As a result, it is possible to reduce or remove single shot-type noise or periodic noise having a rise or fall time longer than the pulse width of the partial discharge pulse signal. Further, the pulse signal in the form of the pulse series provided by the first and second phase shift/reduction circuits can be reverse-converted to a single pulse having a waveform analogous to that of the original pulse, by the phase shift/multiplying circuit, the S/N ratio of the pulse being improved by the output circuit. Furthermore, the embodiment having variable delay times can reduce the noise without deforming the pulse signal, in comparison with a conventional device using a filter.

**Claims**

1. A partial discharge measuring device for use with high voltage apparatus, the device being responsive to an input first signal composed of a partial discharge pulse signal having a pulse width in a predetermined time range and overlapped therewith a single shot or periodic noise signal having a rise or fall time longer than said predetermined time range; characterised by a first phase shift/reduction circuit (11) for producing a second signal delayed relative to said first signal by a predetermined time and for producing a third signal as the difference between said second signal and said first signal; a second phase shift/reduction circuit (14) for producing a fourth signal by delaying said third signal by the predetermined time and for producing a fifth signal as the difference between said fourth signal and said third signal; and a phase shift/multiplying circuit (17) for producing a sixth signal by delaying said fifth signal by a time twice the predetermined time and for multiplying said fifth and sixth signals together to provide the partial discharge pulse signal substantially without any said noise signal.

2. A device as claimed in claim 1, characterised in that said predetermined time is 2nS to 4nS.

3. A device as claimed in claim 1, characterised in that said predetermined time is 10nS to 30nS.

4. A device as claimed in any one of claims 1 to 3, characterised in that each of said first and second phase shift/reduction circuits (11,14) comprises a 180° distributor (21) comprising a high frequency transformer (22) and a mixer (24) comprising a high frequency transformer or resistance means, the 180° distributor being connected through a delay circuit (23) to the mixer.

5. A device as claimed in any preceding claim, characterised in that the predetermined time is variable according to the width of the partial discharge pulse which is dependent upon the kind of partial discharge.

6. A device as claimed in any preceding claim, characterised in that the input signal is supplied to the first phase shift/reduction means through a bandpass amplifier (90) having a pass band of 50MHz to 1000MHz.

**Patentansprüche**

1. Teilentladungsmessvorrichtung zur Benützung mit Hochspannungseinrichtungen, die Vorrichtung spricht auf ein erstes Eingangssignal an, das aus einem Teilentladungsimpulssignal mit einer Impulsbreite innerhalb eines vorbestimmten Zeitbereiches und einen dasselbe überlappenden einzelnen Schrotsignal oder einem periodischen Rauschsignal, dessen Anstiegs- oder Abfallzeit länger ist als der genannte vorbestimmte Zeitbereich, zusammengesetzt ist, gekennzeichnet durch einen ersten Phasenverschiebungsreduktionskreis (11) zum Erzeugen eines zweiten Signals, das bezüglich des genannten ersten Signals um eine vorbestimmte Zeit verzögert ist, und zum Erzeugen eines dritten Signals, das der Differenz zwischen dem genannten zweiten Signal und dem genannten ersten Signal entspricht, einen zweiten Phasenverschiebungsreduktionskreis (14) zum Erzeugen eines vierten Signals durch Verzögern des genannten dritten Signals um die vorbestimmte Zeit und zum Erzeugen eines fünften Signals, das der Differenz zwischen dem genannten vierten Signal und dem genannten dritten Signal entspricht und einem Phasenverschiebungsmultiplikationskreis (17) zum Erzeugen eines sechsten Signals durch Verzögern des genannten fünften Signals um die doppelte vorbestimmte Zeit und zum Multiplizieren des genannten fünften Signals mit dem sechsten Signal zum Erzeugen des Teilentladungsimpulssignals, das im wesentlichen keine der genannten Rauschsignale enthält.

2. Vorrichtung nach Anspruch 1, dadurch gekennzeichnet, dass die genannte vorbestimmte Zeit 2 bis 4 ns ist.

3. Vorrichtung nach Anspruch 1, dadurch gekennzeichnet, dass die genannte vorbestimmte Zeit 10 bis 30 ns ist.

4. Vorrichtung nach einem der Ansprüche 1 bis 3, dadurch gekennzeichnet, dass der erste und der zweite Phasenverschiebungsreduktionskreis (11, 14) je einen 180°-Verteiler (21) mit einem Hochfrequenztransformator (22) und einem Mischer (24) umfasst, dass der Mischer (24) einen Hochfrequenztransformator oder Widerstandsmittel enthält, und dass der 180°-Verteiler über einen Verzögerungskreis (23) mit dem Mischer verbunden ist.

5. Vorrichtung nach einem der vorangehenden Ansprüche, dadurch gekennzeichnet, dass die vorbestimmte Zeit in Abhängigkeit von der Breite des Teilentladungsimpulses variabel ist, welcher seinerseits von der Art der Teilentladung abhängig ist.

6. Vorrichtung nach einem der vorangehenden Ansprüche, dadurch gekennzeichnet, dass das Eingangssignal dem ersten Phasenverschiebungsreduktionskreis über ein Bandpassfilter (90) mit einer Durchlassbandbreite von 50 bis 1000 MHz zugeführt ist.

## Revendications

1. Dispositif de mesure de décharge partielle pour utilisation avec des appareils à haute tension, le dispositif répondant à un premier signal d'entrée composé d'un signal d'impulsion de décharge partielle ayant une largeur d'impulsion dans une gamme de temps prédéterminée et chevauchée par un unique signal de bruit ou un signal de bruit périodique ayant un temps de montée ou de descente plus long que ladite gamme de temps prédéterminée, caractérisé en ce qu'il comporte un premier circuit de réduction à déplacement de phase (11) afin de produire un second signal, retardé relativement audit premier signal d'un temps prédéterminé et produisant un troisième signal qui représente la différence entre ledit second signal et ledit premier signal, un second circuit de réduction à déplacement de phase (14) afin de produire un quatrième signal par retardement dudit troisième signal du temps prédéterminé et afin de produire un cinquième signal qui représente la différence entre ledit quatrième signal et ledit troisième signal, et un circuit de multiplication à déplacement de phase (17) afin de produire un sixième signal par retardement dudit cinquième signal d'un temps double du temps prédéterminé, et afin de multiplier ensemble lesdits cinquième et sixième signaux afin d'obtenir le signal d'impulsion partielle substantiellement exempt de tout dit signal de bruit.

2. Dispositif selon la revendication 1, caractérisé en ce que ledit temps prédéterminé est 2 ns à 4 ns.

3. Dispositif selon la revendication 1, caractérisé en ce que ledit temps prédéterminé est 10 ns à 30 ns.

4. Dispositif selon l'une quelconque des revendications 1 à 3, caractérisé en ce que chacun desdits premier et second circuits de réduction à déplacement de phase (11, 14) comprend un distributeur 180° (21) comprenant un transformateur à haute fréquence (22) et un mélangeur (24) comprenant un transformateur à haute fréquence ou des moyens de résistance, le distributeur 180° etant connecte a travers un circuit de retardement (23) au mélangeur.

5. Dispositif selon l'une quelconque des revendications précédentes, caractérisé en ce que le temps prédéterminé est variable selon la largeur de l'impulsion de décharge partielle qui est dépendante du type de décharge partielle.

6. Dispositif selon l'une quelconque des revendications précédentes, caractérisé en ce que le signal d'entrée est appliqué aux premiers moyens de réduction à déplacement de phase à travers un amplificateur de bande de passage (90) ayant une bande de passage de 50 MHz à 1000 MHz.

FIG. 1

FIG. 2

1

FIG. 3`

# FIG. 4

FIG. 5

FIG. 6

FIG. 7

FIG. 8

FIG. 9

FIG. 10

FIG. 11

FIG. 12

FIG. 13

*FIG. 14*

*FIG. 15*

*FIG. 16*

*FIG. 17*